# EUROPEAN PATENT APPLICATION

(11) **EP 3 315 559 A1**
(43) Date of publication of application: **02.05.2018**
(21) Application number: 15901587.4
(22) Date of filing: 18.11.2015
(51) Int. Cl.: C08L 83/07, C08L 83/05, C08K 3/22, H05K 1/05, B32B 15/08

(54) **ORGANIC SILICONE RESIN ALUMINUM BASE COPPER CLAD LAMINATE AND PREPARATION METHOD THEREOF**

(30) Priority: 19.08.2015 CN 201510510892
(71) Applicant: Shengyi Technology Co., Ltd., Dongguan City, Guangdong 523808 (CN)
(72) Inventor: TANG, Guofang, Dongguan Guangdong 523808 (CN); YE, Suwen, Dongguan Guangdong 523808 (CN)
(74) Representative: Ricker, Mathias
(86) International application number: PCT/CN2015/094879
(87) International publication number: WO 2017/028383

(57) **Abstract**

The present invention relates to an organic silicone resin aluminum base copper clad laminate and preparation method thereof. The aluminum base copper clad laminate comprises sequentially a copper foil layer, an insulation layer and an aluminum plate layer, wherein, the insulation layer is prepared from an organic silicone resin composition, and the organic silicone resin composition comprises the following components in parts by weight: 100 parts of an organic silicone resin, 40-100 parts of a vinyl-terminated silicone oil, 0.0001-0.5 parts of a catalyst, and 0.00001-0.1 parts of an inhibitor. By adopting an organic silicone resin as a substrate polymer, the electrical insulation and heat resistance functions of the aluminum base copper clad laminate are improved. Moreover, the vinyl-terminated silicone oil as reactive diluent can effectively reduce brittleness of a silicone resin, improving the toughness of the organic silicone resin composition. The aluminum base copper clad laminate has advantageous electrical insulation, heat-conduction, high-temperature resistance and resistance to long-term aging.

## Description

### Technical field

The present invention belongs to the technical field of copper clad laminates, and relates to an organosilicone resin aluminum-based copper clad laminate and preparation method thereof.

### Background art

Since entering the 1990s, the heat dissipation of electronic products has undoubtedly become one of the biggest challenges which are faced by electronic designers. With the continuous development of PCB in the direction of high-density and multi-layer, the space for carrying and installing components on the PCB is significantly reduced, and the whole electronic product has an increasingly higher requirement on the power of the power components. The heat per unit area generated during working is getting increased, and if the heat cannot be dissipated in time, the reliability and service life of electronic products will decrease. The thermal conductivity of traditional FR-4 copper clad laminate is only 0.18-0.25 W/(m·K), and thus it cannot meet the requirements on rapid cooling of end products.

The existing aluminum-based copper clad laminate is usually composed of a three-layer structure of copper foil, insulation layer and aluminum plate. The insulation layer is formed by impregnating a glass fiber cloth with resin system and then conducting semi-solidification at high temperature. Although this insulation sheet has both thermal conductive performance and insulation performance, it has drawbacks that: ① the glass fiber cloth has high thermal resistance, poor heat dissipation, and thus is difficult to meet the needs of electronic products with high-power, high heat dissipation; ② the insulation layer of glass fiber cloth is prone to having a problem of brittleness during processing, resulting in an increased rejection rate of products.

CN 103275671A discloses a thermal conductive organosilicone pouring sealant. Although the organosilicone pouring sealant has excellent thermal conductivity, since carbon nanotube is introduced therein and carbon nanotube has a same structure with graphite sheet and thus has a certain electrical conductivity, it is not suitable for use in the insulating layer of an aluminum-based copper clad laminate which has a higher requirement on electrical insulation property.

### Disclosure of the invention

In view of the problems existing in the prior art, the first purpose of the present invention is to provide an organosilicone resin aluminum-based copper clad laminate, which has excellent electrical insulation property, thermal conductivity, high-temperature resistance and long-term aging resistance.

In order to achieve the above purpose, the present invention utilizes the following technical solution.

An organosilicone resin aluminum-based copper clad laminate comprises a copper foil layer, an insulation layer and an aluminum plate layer, which are sequentially arranged, wherein the insulation layer is prepared from an organosilicone resin composition comprising the following components in parts by weight:

| | |
|---|---|
| organosilicone resin | 100 parts |
| vinyl-terminated silicone oil | 40-100 parts |
| catalyst | 0.0001-0.5 parts |
| inhibitor | 0.00001-0.1 parts. |

The organosilicone resin is a thermosetting resin, and only organic groups on side chains thereof break and decompose during thermal oxidation at high temperature and oxides thereof escape therefrom, while the silicon oxygen bonds on main chains is rarely destroyed, resulting in a polymer having a -O-Si-O- form. The silicon oxygen bond Si-O has a bond energy of 451 kJ/mol, and thus the polymer has heat resistance far superior to conventional organic resins and can be used under 200°C in a long term. Another prominent performance of organosilicone resin is excellent electrical insulation property. Since there is a layer of non-polar organic groups on the external of silicone macromolecule main chain and the macromolecular chain has molecular symmetry, organosilicone resin has excellent electrical insulation property, and the dielectric loss, voltage and arc resistance, volume resistivity, surface resistivity and the like thereof are among the best in insulation materials. The vinyl-terminated silicone oil is used as a reactive diluent, and thereby a toxic solvent is not used, which is conducive to environmental protection relative to ordinary resins. Further, the reactive diluent can participate in the reaction, effectively reduce the brittleness of organosilicone resin, and improve the toughness of the organosilicone resin composition. The aluminum-based copper clad laminate has excellent electrical insulation property, thermal conductivity, high-temperature resistance and long-term aging resistance.

In the present invention, the content of the vinyl-terminated silicone oil is, for example, 45 parts, 50 parts, 55 parts, 60 parts, 65 parts, 70 parts, 75 parts, 80 parts, 85 parts, 90 parts or 95 parts.

The content of the catalyst is, for example, 0.0005 parts, 0.01 parts, 0.05 parts, 0.1 parts, 0.15 parts, 0.2 parts, 0.25 parts, 0.3 parts, 0.35 parts, 0.4 parts or 0.45 parts.

The content of the inhibitor is, for example, 0.00005 parts, 0.0001 parts, 0.0005 parts, 0.0008 parts, 0.001 parts, 0.003 parts, 0.006 parts, 0.01 parts, 0.03 parts, 0.05 parts, 0.07 parts or 0.09 parts.

In the present invention, the organosilicone resin composition further comprises a thermal conductive filler. An aluminum substrate having high thermal conductivity can be obtained by adding a thermal conductive filler.

Preferably, the thermal conductive filler is any one selected from the group consisting of aluminum oxide, aluminum nitride, boron nitride, silicon carbide, magnesium oxide, zinc oxide and silicon dioxide, or a mixture of at least two of them.

Preferably, the volume percentage of the thermal conductive filler to the organosilicone resin composition is 20-45%, for example 22%, 24%, 26%, 28%, 30%, 32%, 34%, 36%, 38%, 40%, 42% or 44%.

Preferably, the organosilicone resin composition further comprises a white filler. A white aluminum substrate can be obtained by adding a white filler.

Preferably, the white filler is any one selected from the group consisting of aluminum oxide, titanium dioxide, aluminum hydroxide, silicon dioxide and zinc oxide, or a mixture of at least two of them.

Preferably, the mass percentage of the white filler to the organosilicone resin composition is 0-30%, for example 1%, 3%, 5%, 8%, 11%, 14%, 17%, 20%, 23%, 26% or 29%.

In the present invention, the particle diameters of the thermal conductive filler and the white filler are not particularly limited, but preferably are 10 µm or less, and more preferably are 5 µm or less.

In the present invention, the organosilicone resin is a thermosetting silicone resin including methylvinyl silicone resin or/and methylphenylvinyl silicone resin, both of which can be subjected to an addition reaction by use of a crosslinking agent under mild conditions, without forming small molecules and other byproducts and without forming bubbles, and has excellent electrical insulation property. Moreover, the organosilicone resin does not utilize solvent and thus is environmentally friendly.

Meanwhile, the lower the mass fraction of vinyl is, the more the resin tends to be silicone rubber, the lower the hardness is and the better the flexibility is after curing. However, when the mass fraction of vinyl is lower than a certain value, the resin composition is gelled after being cured, and thus cannot be used in an aluminum substrate. Further, the higher the mass fraction of vinyl is, the better the thermosetting property of the resin is, but the brittler the resin is and the lower the mechanical property is. Therefore, the mass fraction of vinyl in the organosilicone resin is 0.5-6.0%, such as 1%, 1.5%, 2 %, 2.5%, 3%, 3.5%, 4%, 4.5%, 5%, 5.5% or 6%, preferably the mass fraction of vinyl is 0.8-4.5%.

Preferably, the organosilicone resin composition further comprises a cross-linking agent, which performs a cross-linking reaction with the organosilicone resin.

Preferably, the crosslinking agent is any one selected from the group consisting of methyl hydrogen silicone oil, methyl phenyl hydrogen silicone oil, methyl hydrogen silicone resin and methyl phenyl hydrogen silicone resin, or a mixture of at least two of them.

Preferably, the molar ratio of Si-H (silicon hydrogen) in the crosslinking agent to Si-Vi (silicon vinyl) in the organosilicone resin is 1.0-1.7, for example 1.05, 1.1, 1.15, 1.2, 1.25, 1.3, 1.35, 1.4, 1.45, 1.5, 1.55, 1.6, or 1.65. The molar ratio of Si-H (silicon hydrogen) to Si-Vi (silicon vinyl) is ideally calculated as 1.0. However, since Si-H (silicon hydrogen) in the crosslinking agent can easily generate hydrogen gas on its own during high-temperature reaction with the removal of Si-H, the molar ratio of Si-H to Si-Vi will be higher in practical applications. However, the molar ratio of Si-H to Si-Vi should not be too high. If it is too high, the amount of hydrogen gas generated will increase, resulting in holes in the laminate after curing. Therefore, the mole ratio of Si-H to Si-Vi is suitably 1.0-1.7, and preferably 1.2-1.6.

Preferably, the crosslinking agent has a hydrogen mass fraction of 0.5-1.6%, for example 0.6%, 0.7%, 0.8%, 0.9%, 1.0%, 1.1%, 1.2%, 1.3%, 1.4% or 1.5%, preferably 0.7-1.3%.

In the present invention, the amount of the crosslinking agent is calculated from the molar ratio of Si-H (silicon hydrogen)/Si-Vi (silicon vinyl) and the vinyl content and the mass fraction of the organosilicone resin.

The curing method of the organosilicone resin composition of the present invention is as follows: Si-CH=CH₂ and Si-H bonds are reacted under the catalysis of the catalyst to form a crosslinked network structure. The specific reaction formula is as follow:

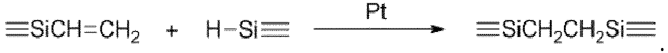

In the present invention, the vinyl-terminated silicone oil is used as a reactive diluent for the organosilicone resin composition, and preferably comprises methyl vinyl-terminated silicone oil or/and methylphenyl vinyl-terminated silicone oil, and the vinyl-terminated silicone oil itself participates in the reaction. When the viscosity of the vinyl-terminated silicone oil is lower, the effects of diluting and dissolving the silicone resin are better, but curd product is brittler. When the viscosity of the vinyl-terminated silicone oil is higher, the vinyl-terminated silicone oil can play a toughening effect on the silicone resin, but the dilution effect on the silicone resin is reduced. Therefore, the viscosity of the vinyl-terminated silicone oil is 200-10000 mPa·s, preferably 500-8000 mPa·s.

In the present invention, the organosilicone resin composition further comprises a catalyst, and the catalyst is a platinum catalyst, preferably is platinum-methylvinyl complex or/and platinum-methylphenylvinyl complex. Preferably, the catalyst has a viscosity of 100-10000 mPa·s.

In the present invention, the inhibitor is any one selected from the group consisting of alkynyl-containing compound, polyvinyl-containing compound, nitrogen-containing organic compound, phosphorus-containing organic compound, and sulphur-containing organic compound, or a mixture of at least two of them.

In the present invention, the organosilicone resin composition further comprises 0.1-5 parts of an auxiliary agent, for example 0.5 parts, 1.0 parts, 1.5 parts, 2.0 parts, 3.0 parts, 4.0 parts or 5.0 parts.

Preferably, the auxiliary agent is a coupling agent and/or a dispersing agent.

Preferably, the organosilicone resin composition comprises the following components in parts by weight:

| | |
|---|---|
| organosilicone resin | 100 parts |
| vinyl-terminated silicone oil | 40-100 parts |
| auxiliary agent | 0.1-5 parts |
| catalyst | 0.0001-0.5 parts |
| inhibitor | 0.00001-0.1 parts; |

thermal conductive filler, which accounts for 20-45 % by volume of the organosilicone resin composition, and white filler, which accounts for 0-30 % by mass of the organosilicone resin composition;
The crosslinking agent for the organosilicone resin is any one selected from the group consisting of methyl hydrogen silicone oil, methyl phenyl hydrogen silicone oil, methyl hydrogen silicone resin and methyl phenyl hydrogen silicone resin, or a mixture of at least two of them; the molar ratio of Si-H in the cross-linking agent to Si-Vi in the organosilicone resin is 1.0-1.7.

The terms "comprise(s)/comprising" and "include(s)/including" used in the present invention mean that in addition to the components described, other components which give the organosilicone resin composition different characteristics can also be included. In addition, the terms "comprise(s)/comprising" and "include(s)/including" used in the present invention may also be replaced by a closed description as "is/are /being" or "consist(s) of/consisting of'.

For example, the organosilicone resin composition can also comprise a variety of additives, for example flame retardant, antioxidant, heat stabilizer, antistatic agent, UV absorber, pigment, colorant, or lubricant and others. These additives can be used alone, and can also be used in the form of a mixture of two or more of them.

The second purpose of the present invention is to provide a method for preparing the organosilicone resin aluminum-based copper clad laminate as described above, comprising the following steps:
(1) mixing the components according to the composition of the organosilicone resin composition as described above to obtain an organosilicone resin glue solution;
(2) coating the organosilicone resin glue solution on a copper foil without curing treatment, to obtain a coated copper foil;
(3) superimposing an aluminum plate and the coated copper foil, and then compression molding them under vacuum to obtain an organosilicone resin aluminum-based copper clad laminate.

The compression molding can be carried out by step-wise heating and pressurizing.

Compared with the prior art, the present invention has the following beneficial effects:
The organosilicone resin is a thermosetting resin, and only organic groups on side chains thereof break and decompose during thermal oxidation at high temperature, and thus oxides thereof escape therefrom, while the silicon oxygen bonds on main chains is rarely destroyed, resulting in a polymer having a -O-Si-O- form. The silicon oxygen bond Si-O has a bond energy of 451 kJ/mol, and thus the polymer has heat resistance far superior to conventional organic resins and can be used under 200°C in a long term. Another prominent performance of organosilicone resin is excellent electrical insulation property. Since there is a layer of non-polar organic groups on the external of silicone macromolecule main chain and the macromolecular chain has molecular symmetry, organosilicone resin has excellent electrical insulation property, and the dielectric loss, voltage and arc resistance, volume resistivity, surface resistivity and the like thereof are among the best in insulation materials. The vinyl-terminated silicone oil is used as a reactive diluent, and thereby a toxic solvent is not used, which is conducive to environmental protection relative to ordinary resins. Further, the reactive diluent can participate in the reaction, effectively reduce the brittleness of organosilicone resin, and improve the toughness of the organosilicone resin composition.

In addition, in the present invention, a high thermal conductive aluminum-based copper clad laminate and a white aluminum-based copper clad laminate can be obtained by adding a thermal conductive filler and a white filler to the organosilicone resin composition respectively.

### Embodiments

The technical solutions of the present invention are further explained by combining with the following examples.

### Example 1

A formulation was designed based on Si-H (silicon hydrogen)/Si-Vi (silicon vinyl) = 1.6 (molar ratio). 100 parts of methylphenyl vinyl silicone resin (mass fraction of vinyl being 1.0%) was weighted and dissolved in 50 parts of methylphenyl vinyl-terminated silicone oil having a viscosity of 250 mPa·s. After dissolving homogeneously, 4.56 parts of methylphenyl hydrogen silicone oil (mass fraction of hydrogen being 1.3%) and 0.1 parts of γ-glycidyloxypropyltrimethoxysilane (produced by Dow Corning, U.S.) were added therein. After stirring to be homogeneous at high speed, 0.001 parts of hexynol was weighed. 0.01 parts of platinum-methylphenylvinyl complex was added after stirring for 30 minutes, and then 150 parts of boron nitride having a particle size of 3.5 µm was added after stirring for another 30 minutes. Then the mixture was stirred at room temperature for 1 h, and emulsified for 20 min to obtain an organosilicone resin composition.

A 35 µm clean copper foil was coated with a glue layer of the above organosilicone resin composition having a thickness of 100 µm by an automatic coater. The coated copper foil and an aluminum plate were placed together and then placed in a hot press, and then were compression molded at 200°C, under a surface pressure of 10 kgf/cm² and a vacuum of 30 mmHg or less for 180 minutes to obtain an aluminum-based copper clad laminate.

### Example 2

A formulation was designed based on Si-H/Si-Vi = 1.4 (molar ratio). 100 parts of methyl vinyl silicone resin (mass fraction of vinyl being 3.5%) was weighted and dissolved in 70 parts of methyl vinyl-terminated silicone oil having a viscosity of 3000 mPa·s. After dissolving homogeneously, 18.15 parts of methyl hydrogen silicone oil (mass fraction of hydrogen being 1.0%) and 1.8 parts of W-903 dispersing agent (produced by BYK company, Germany) were added therein. After stirring to be homogeneous at high speed, 0.00005 parts of hexynol was weighed. 0.005 parts of platinum-methylvinyl complex was added after stirring for 30 minutes, and then 38 parts of silicon carbide having a particle size of 35 µm, 300 parts of aluminum oxide having a particle size of 3.5 µm and 40 parts of rutile titanium dioxide were added after stirring for another 30 minutes. Then the mixture was stirred at room temperature for 1 h, and emulsified for 20 min to obtain an organosilicone resin composition.

An aluminum-based copper clad laminate was obtained by the same method with Example 1, except using this resin composition.

### Example 3

A formulation was designed based on Si-H/Si-Vi = 1.1 (molar ratio). 100 parts of methyl vinyl silicone resin (mass fraction of vinyl being 5.5%) was weighted and dissolved in 100 parts of methyl vinyl-terminated silicone oil having a viscosity of 9500 mPa·s. After dissolving homogeneously, 28.0 parts of methyl hydrogen silicone oil (mass fraction of hydrogen being 0.8%) and 4.5 parts of γ-glycidyloxypropyltrimethoxysilane (produced by Dow Corning, U.S.) were added therein. After stirring to be homogeneous at high speed, 0.001 parts of tetramethyl tetravinyl cyclotetrasiloxane (D4vi) was weighed. 0.0001 parts of platinum-methylvinyl complex was added after stirring for 30 minutes, and then 55 parts of aluminum oxide having a particle size of 3.5 µm and 155 parts of aluminum nitride were added after stirring for another 30 minutes. Then the mixture was stirred at room temperature for 1 h, and emulsified for 20 min to obtain an organosilicone resin composition.

An aluminum-based copper clad laminate was obtained by the same method with Example 1, except using this resin composition.

### Comparative Example 1

A formulation was designed based on Si-H (silicon hydrogen)/Si-Vi (silicon vinyl) = 1.6 (molar ratio). 100 parts of methylphenylvinyl silicone resin (mass fraction of vinyl being 1.0%) was weighted and dissolved in 50 parts of methylphenyl vinyl-terminated silicone oil having a viscosity of 250 mPa·s. After dissolving homogeneously, 4.56 parts of methylphenyl hydrogen silicone oil (mass fraction of hydrogen being 1.3%) and 0.1 parts of γ-glycidyloxypropyltrimethoxysilane (produced by Dow Corning, U.S.) were added therein. After stirring to be homogeneous at high speed, 0.001 parts of hexynol was weighed. 0.01 parts of platinum-methylphenylvinyl complex was added after stirring for 30 minutes, and then 300 parts of boron nitride having a particle size of 3.5 µm was added after stirring for another 30 minutes. Then the mixture was stirred at room temperature for 1 h, and emulsified for 20 min to obtain a silicone resin composition.

An aluminum-based copper clad laminate was obtained by the same method with Example 1, except using this resin composition.

### Comparative Example 2

A formulation was designed based on Si-H/Si-Vi = 1.4 (molar ratio). 100 parts of methylvinyl silicone resin (mass fraction of vinyl being 3.5%) was weighted and dissolved in 70 parts of methyl vinyl-terminated silicone oil having a viscosity of 3000 mPa·s. After dissolving homogeneously, 18.15 parts of methyl hydrogen silicone oil (mass fraction of hydrogen being 1.0%) and 1.8 parts of W-903 dispersing agent (produced by BYK company, Germany) were added therein. After stirring to be homogeneous at high speed, 0.00005 parts of hexynol was weighed. 0.005 parts of platinum-methylvinyl complex was added after stirring for 30 minutes, and then 20 parts of silicon carbide having a particle size of 35 µm, 100 parts of aluminum oxide having a particle size of 3.5 µm and 40 parts of rutile titanium dioxide were added after stirring for another 30 minutes. Then the mixture was stirred at room temperature for 1 h, and emulsified for 20 min to obtain a silicone resin composition.

An aluminum-based copper clad laminate was obtained by the same method with Example 1, except using this resin composition.

### Comparative Example 3

A formulation was designed based on Si-H/Si-Vi = 1.1 (molar ratio). 100 parts of methyl vinyl silicone resin (mass fraction of vinyl being 10.0%) was weighted and dissolved in 100 parts of methyl vinyl-terminated silicone oil having a viscosity of 9500 mPa·s. After dissolving homogeneously, 50.9 parts of methyl hydrogen silicone oil (mass fraction of hydrogen being 0.8%) and 4.5 parts of γ-glycidyloxypropyltrimethoxysilane (produced by Dow Corning, U.S.) were added therein. After stirring to be homogeneous at high speed, 0.1 parts of tetramethyl tetravinyl cyclotetrasiloxane (D4vi) was weighed. 0.0001 parts of platinum-methylvinyl complex was added after stirring for 30 minutes, and then 55 parts of aluminum oxide having a particle size of 3.5 µm and 155 parts of aluminum nitride were added after stirring for another 30 minutes. Then the mixture was stirred at room temperature for 1 h, and emulsified for 20 min to obtain a silicone resin composition.

An aluminum-based copper clad laminate was obtained by the same method with Example 1, except using this resin composition.

### Comparative Example 4

A formulation was designed based on Si-H/Si-Vi = 0.7 (molar ratio). 100 parts of methyl vinyl silicone resin (mass fraction of vinyl being 5.5%) was weighted and dissolved in 100 parts of methyl vinyl-terminated silicone oil having a viscosity of 9500 mPa·s. After dissolving homogeneously, 17.8 parts of methyl hydrogen silicone oil (mass fraction of hydrogen being 0.8%) and 4.5 parts of γ-glycidyloxypropyltrimethoxysilane (produced by Dow Corning, U.S.) were added therein. After stirring to be homogeneous at high speed, 0.1 parts of tetramethyl tetravinyl cyclotetrasiloxane (D4vi) was weighed. 0.0001 parts of platinum-methylvinyl complex was added after stirring for 30 minutes, and then 55 parts of aluminum oxide having a particle size of 3.5 µm and 155 parts of aluminum nitride were added after stirring for another 30 minutes. Then the mixture was stirred at room temperature for 1 h, and emulsified for 20 min to obtain an organosilicone resin composition.

An aluminum-based copper clad laminate was obtained by the same method with Example 1, except using this resin composition.

### Comparative Example 5

A formulation was designed based on Si-H (silicon hydrogen)/Si-Vi (silicon vinyl) = 1.6 (molar ratio). 100 parts of methylphenylvinyl silicone resin (mass fraction of vinyl being 1.0%) was weighted and dissolved in 50 parts of toluene. After dissolving homogeneously, 4.56 parts of methylphenyl hydrogen silicone oil (mass fraction of hydrogen being 1.3%) and 0.1 parts of γ-glycidyloxypropyltrimethoxysilane (produced by Dow Corning, U.S.) were added therein. After stirring to be homogeneous at high speed, 0.001 parts of hexynol was weighed. 0.01 parts of platinum-methylphenylvinyl complex was added after stirring for 30 minutes, and then 150 parts of boron nitride having a particle size of 3.5 µm was added after stirring for another 30 minutes. Then the mixture was stirred at room temperature for 1 h, and emulsified for 20 min to obtain a silicone resin composition.

A 35 µm clean copper foil was coated with a glue layer of the above silicone resin composition having a thickness of 100 µm by an automatic coater. After being baked for 1 h at 50°C to remove solvent, the coated copper foil and an aluminum plate were placed together and then placed in a hot press, and then were compression molded at 200°C, under a surface pressure of 10 kgf/cm² and a vacuum of 30 mmHg or less for 180 minutes to obtain an aluminum-based copper clad laminate.

### Comparative Example 6

A formulation was designed based on Si-H (silicon hydrogen)/Si-Vi (silicon vinyl) = 1.6 (molar ratio). 100 parts of methylphenylvinyl silicone resin (mass fraction of vinyl being 1.0%) was weighted and dissolved in 30 parts of methylphenyl vinyl-terminated silicone oil having a viscosity of 250 mPa·s. After dissolving homogeneously, 4.56 parts of methylphenyl hydrogen silicone oil (mass fraction of hydrogen being 1.3%) and 0.1 parts of γ-glycidyloxypropyltrimethoxysilane (produced by Dow Corning, U.S.) were added therein. After stirring to be homogeneous at high speed, 0.001 parts of hexynol was weighed. 0.01 parts of platinum-methylphenylvinyl complex was added after stirring for 30 minutes, and then 150 parts of boron nitride having a particle size of 3.5 µm was added after stirring for another 30 minutes. Then the mixture was stirred at room temperature for 1 h, and emulsified for 20 min to obtain an organosilicone resin composition.

A 35 µm clean copper foil was coated with a glue layer of the above silicone resin composition having a thickness of 100 µm by an automatic coater. The coated copper foil and an aluminum plate were placed together and then placed in a hot press, and then were compression molded at 200°C, under a surface pressure of 10 kgf/cm² and a vacuum of 30 mmHg or less for 180 minutes to obtain an aluminum-based copper clad laminate.

### Comparative Example 7

A formulation was designed based on Si-H (silicon hydrogen)/Si-Vi (silicon vinyl) = 1.6 (molar ratio). 100 parts of methylphenylvinyl silicone resin (mass fraction of vinyl being 1.0%) was weighted and dissolved in 120 parts of methylphenyl vinyl-terminated silicone oil having a viscosity of 250 mPa·s. After dissolving homogeneously, 4.56 parts of methylphenyl hydrogen silicone oil (mass fraction of hydrogen being 1.3%) and 0.1 parts of γ-glycidyloxypropyltrimethoxysilane (produced by Dow Corning, U.S.) were added therein. After stirring to be homogeneous at high speed, 0.001 parts of hexynol was weighed. 0.01 parts of platinum-methylphenylvinyl complex was added after stirring for 30 minutes, and then 150 parts of boron nitride having a particle size of 3.5 µm was added after stirring for another 30 minutes. Then the mixture was stirred at room temperature for 1 h, and emulsified for 20 min to obtain an organosilicone resin composition.

A 35 µm clean copper foil was coated with a glue layer of the above silicone resin composition having a thickness of 100 µm by an automatic coater. The coated copper foil and an aluminum plate were placed together and then placed in a hot press, and then were compression molded at 200°C, under a surface pressure of 10 kgf/cm² and a vacuum of 30 mmHg or less for 180 minutes to obtain an aluminum-based copper clad laminate.

### Comparative Example 8

Firstly, 54.49 g (0.4 mol) of methyltrimethoxysilane, 14.82 g (0.1 mol) of vinyltrimethoxysilane and 70 g of toluene were weighed sequentially, mixed uniformly, and poured into a 250 ml four-necked flask equipped with cooling, stirring and heating devices. Then 32.40 g of an aqueous solution of hydrochloric acid with pH = 1 was added slowly dropwise at 30°C, after which the mixture was warmed to 50°C to continue the reaction for 5-6 h. Then the reaction product was separated, washed with water to neutral, and then was distilled under reduced pressure, thereby 31.5 g of a colorless, transparent organosilicone resin having a viscosity of 31850 mPa·S, a vinyl content of 7.2% and a yield of 93.5% was obtained. 6.0 g of organosilicone resin product, 1.4 g of vinyl silicone oil (η = 10000 mPa·S, Vi% = 0.4), 2.0 g of hydrosilicone resin (η = 630 mPa·S, H% = 1.0), 0.04 g of Karstedt catalyst (5000 ppm), 0.16 g of KH-560/550 (9/1) hydrolyzate and 0.01 g of acetylene cyclohexanol were weighed and mixed uniformly in a 100 ml flask to obtain a silicone resin composition.

A 35 µm clean copper foil was coated with a glue layer of the above silicone resin composition having a thickness of 100 µm by an automatic coater. The coated copper foil and an aluminum plate were placed together and then placed in a hot press, and then were compression molded at 200°C, under a surface pressure of 10 kgf/cm² and a vacuum of 30 mmHg or less for 180 minutes to obtain an aluminum-based copper clad laminate.

The aluminum-based copper clad laminates prepared in Examples 1-3 and Comparative Examples 1-8 above were tested for their thermal conductivity, peeling strength, voltage resistance (Hi-pot), and dip soldering limiting resistance.

Test methods for the above performances are as follows:
thermal conductivity was tested by ASTM D5470 standard method;
peeling strength was tested by IPC-TM-650 2.4.8 method; and
dip soldering resistance was tested by IPC-TM-650 2.4.13.1 method.

The main parameters and experimental data of Examples 1-3 and Comparative Examples 1-8 are shown in Tables 1 and 2.

**Table 1**

| Test Items | Example 1 | Example 2 | Example 3 |
|---|---|---|---|
| Parts of silicone resin | 100 | 100 | 100 |
| Vinyl content (%) | 1.0 | 3.5 | 5.5 |
| Si-H/Si-Vi (molar ratio) | 1.6 | 1.4 | 1.1 |
| Filler content | 150 | 38+300+40 | 55+155 |
| Peeling strength (N/mm) | 0.57 | 0.61 | 0.65 |
| Thermal conductivity (W/m.k) | 2.23 | 1.39 | 1.81 |
| Dip soldering resistance (s) | >300 | >300 | >300 |
| Appearance of insulation layer after etching copper foil | Good appearance | Good appearance | Good appearance |

**Table 2**

| Test Items | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 |
|---|---|---|---|---|---|---|---|---|
| Parts of silicone resin | 100 | 100 | 100 | 100 | 100 | 100 | 100 | 6.0 |
| Vinyl content (%) | 1.0 | 3.5 | 10.0 | 5.5 | 1.0 | 1.0 | 1.0 | 7.2 |
| Si-H/Si-Vi (molar ratio) | 1.6 | 1.4 | 1.1 | 0.7 | 1.6 | 1.6 | 1.6 | 1.25 |
| Filler content | 300 | 20+100 +40 | 55+155 | 55+155 | 150 | 150 | 150 | 0 |
| Peeling strength (N/mm) | 0.29 | 0.63 | 0.43 | 0.50 | 0.31 | 0.37 | 0.53 | 0.49 |
| Thermal conductivity (W/m.k) | 1.62 | 0.48 | 1.4 | 1.54 | 1.28 | 1.66 | 0.93 | 0.27 |
| Dip soldering resistance (s) | >300 | >300 | 186 | 83 | 1 | 35 | 195 | 244 |
| Appearance of insulation layer after etching copper foil | With cracks | Good appeara nce | With micro-c racks | Wrinkle d | Crackin g | With micro-cr acks | Good appearan ce | With micro-cr acks |

### Analysis of physical properties:

Examples 1-3 have high peeling strength, high thermal conductivity, and excellent dip soldering resistance at the same time. Comparative Example 1 has the same composition parameters with Example 1, but the volume content of the thermal conductive filler exceeds the range protected by the present invention. Compared with Example 1, peeling strength of the product of Comparative Example 1 is greatly reduced, and the insulation layer in Comparative Example 1 cracks more seriously. When Comparative Example 2 is compared with Example 2, the volume content of the thermal conductive filler in Comparative Example 2 is lower than the range protected by the present invention, resulting in that thermal conductive channel cannot be formed and thus thermal conductivity is greatly reduced. When Comparative Example 3 is compared with Example 3, the vinyl content of the silicone resin in Comparative Example 3 is higher than the range protected by the present invention, resulting in brittleness after curing of the resin, and thus the insulation layer cracks and the peeling strength and dip soldering resistance decrease. When Comparative Example 4 is compared with Example 3, Si-H/Si-Vi (molar ratio) in Comparative Example 4 is 0.7, and thus the vinyl silicone resin is cured incompletely and overall performances of the resin composition are poorer, which has a bad effect on the dip soldering resistance, and the insulating layer appears wrinkling. Comparative Example 5 employed an inert diluent, toluene, which causes severe cracking of the insulating layer after curing due to the lack of a toughener in the formulation. Comparative Examples 6 and 7 use too small amount and excessive amount of vinyl-terminated silicone oil respectively. When the amount of vinyl-terminated silicone oil is too small, the resin is difficult to dilute, and the viscosity of the glue is high, and thus the process is difficult, the toughness of the cured product is decreased, and cracking easily occurs. When the amount of vinyl-terminated silicone oil is excessive, heat resistance of the glue is decreased, and dip soldering resistance is difficult to meet the needs. Comparative Example 8 is Example 1 of CN 103992645 A, in which the resin composition has an organosilicone resin content of 7.2% and no thermal conductive filler is added to the resin composition, and thus the product has low thermal conductivity, and when the resin composition is applied to an aluminum substrate as an insulation layer, it is more brittle and prone to cracking.

The applicant states that: the present invention illustrates the technical solutions of the present invention by the above examples, but the present invention is not limited to the above examples, that is to say, it does not mean that the present invention must be conducted relying on the above examples. Those skilled in the art should understand that any modification to the present invention, any equivalent replacement of each raw material of the products of the present invention and the additions of auxiliary ingredients, the selections of specific embodiment and the like all fall into the protection scope and the disclosure scope of the present invention.

## Claims

1. An organosilicone resin aluminum-based copper clad laminate, comprising a copper foil layer, an insulation layer and an aluminum plate layer, which are sequentially arranged, wherein the insulation layer is prepared from an organosilicone resin composition comprising the following components in parts by weight:
| | |
|---|---|
| organosilicone resin | 100 parts |
| vinyl-terminated silicone oil | 40-100 parts |
| catalyst | 0.0001-0.5 parts |
| inhibitor | 0.00001-0.1 parts. |

2. The aluminum-based copper clad laminate of claim 1, **characterized in that** the organosilicone resin composition further comprises a thermal conductive filler;
preferably, the thermal conductive filler is any one selected from the group consisting of aluminum oxide, aluminum nitride, boron nitride, silicon carbide, magnesium oxide, zinc oxide and silicon dioxide, or a mixture of at least two of them;
preferably, the volume percentage of the thermal conductive filler to the organosilicone resin composition is 20-45%.

3. The aluminum-based copper clad laminate of claim 1 or 2, **characterized in that** the organosilicone resin composition further comprises a white filler;
preferably, the white filler is any one selected from the group consisting of aluminum oxide, titanium dioxide, aluminum hydroxide, silicon dioxide and zinc oxide, or a mixture of at least two of them;
preferably, the mass percentage of the white filler to the organosilicone resin composition is 0-30%.

4. The aluminum-based copper clad laminate of any one of claims 1-3, **characterized in that** the organosilicone resin is methylvinyl silicone resin or/and methylphenylvinyl silicone resin;
preferably, the mass fraction of vinyl in the organosilicone resin is 0.5-6.0%, preferably the mass fraction of vinyl is 0.8-4.5%.

5. The aluminum-based copper clad laminate of any one of claims 1-4, **characterized in that** the organosilicone resin composition further comprises a cross-linking agent;
preferably, the crosslinking agent is any one selected from the group consisting of methyl hydrogen silicone oil, methyl phenyl hydrogen silicone oil, methyl hydrogen silicone resin and methyl phenyl hydrogen silicone resin, or a mixture of at least two of them;
preferably, the crosslinking agent has a hydrogen mass fraction of 0.5-1.6%, preferably 0.7-1.3%;
preferably, the molar ratio of Si-H (silicon hydrogen) in the crosslinking agent to Si-Vi (silicon vinyl) in the organosilicone resin is 1.0-1.7, preferably 1.2-1.6.

6. The aluminum-based copper clad laminate of any one of claims 1-5, **characterized in that** the vinyl-terminated silicone oil is methyl vinyl-terminated silicone oil or/and methylphenyl vinyl-terminated silicone oil;
preferably, the viscosity of the vinyl-terminated silicone oil is 200-10000 mPa·s, preferably 500-8000 mPa·s.

7. The aluminum-based copper clad laminate of any one of claims 1-6, **characterized in that** the catalyst is a platinum catalyst, preferably the catalyst is platinum-methylvinyl complex or/and platinum-methylphenylvinyl complex;
preferably, the catalyst has a viscosity of 100-10000 mPa·s;
preferably, the inhibitor is any one selected from the group consisting of alkynyl-containing compound, polyvinyl-containing compound, nitrogen-containing organic compound, phosphorus-containing organic compound, and sulphur-containing organic compound, or a mixture of at least two of them.

8. The aluminum-based copper clad laminate of any one of claims 1-7, **characterized in that** the organosilicone resin composition further comprises 0.1-5 parts of an auxiliary agent;
preferably, the auxiliary agent is a coupling agent and/or a dispersing agent.

9. The aluminum-based copper clad laminate of any one of claims 1-8, **characterized in that** the organosilicone resin composition comprises the following components in parts by weight:
| | |
|---|---|
| organosilicone resin | 100 parts |
| vinyl-terminated silicone oil | 40-100 parts |
| auxiliary agent | 0.1-5 parts |
| catalyst | 0.0001-0.5 parts |
| inhibitor | 0.00001-0.1 parts; |
thermal conductive filler, which accounts for 20-45 % by volume of the organosilicone resin composition, and white filler, which accounts for 0-30 % by mass of the organosilicone resin composition;
the crosslinking agent for the organosilicone resin is any one selected from the group consisting of methyl hydrogen silicone oil, methyl phenyl hydrogen silicone oil, methyl hydrogen silicone resin and methyl phenyl hydrogen silicone resin, or a mixture of at least two of them; the molar ratio of Si-H in the cross-linking agent to Si-Vi in the organosilicone resin is 1.0-1.7.

10. A method for preparing the organosilicone resin aluminum-based copper clad laminate of any one of claims 1-9, comprising the following steps:
(1) mixing the components according to the composition of the organosilicone resin composition as described in any one of claims 1-9 to obtain an organosilicone resin glue solution;
(2) coating the organosilicone resin glue solution on a copper foil without curing treatment, to obtain a coated copper foil;
(3) superimposing an aluminum plate and the coated copper foil, and then compression molding them under vacuum to obtain an organosilicone resin aluminum-based copper clad laminate.
